# EUROPEAN PATENT APPLICATION

(11) **EP 4 471 881 A1**
(43) Date of publication of application: **04.12.2024**
(21) Application number: 22929425.1
(22) Date of filing: 31.03.2022
(51) Int. Cl.: H01M 4/02, H01M 4/36, H01M 4/505, H01M 4/525

(54) **SINGLE CRYSTAL SODIUM ION BATTERY POSITIVE ELECTRODE ACTIVE MATERIAL, PREPARATION METHOD THEREFOR, AND USE THEREOF**

(30) Priority: 03.03.2022 CN 202210202111
(71) Applicant: Jiangsu Xiangying New Energy Technology Co., Ltd., Changzhou, Jiangsu 213300 (CN)
(72) Inventor: GONG, Liming, hangzhou, Jiangsu 213300 (CN); JIANG, Wen, hangzhou, Jiangsu 213300 (CN); HUANG, Jie, hangzhou, Jiangsu 213300 (CN); ZHONG, Huan, hangzhou, Jiangsu 213300 (CN)
(74) Representative: De Vries & Metman
(86) International application number: PCT/CN2022/084532
(87) International publication number: WO 2023/164986

(57) **Abstract**

Disclosed is a preparation method for a single-crystal sodium-ion battery cathode material. The single-crystal sodium-ion battery cathode active material comprises: sodium, metal M, boron, and oxygen elements, and the preparation method comprises a step of adding an M-containing compound, a B-containing compound and a sodium source to water to form a slurry and sand grinding the slurry to obtain a mixed slurry and a step of spray drying the mixed slurry and sintering the dried mixed slurry to obtain the single-crystal sodium-ion battery cathode active material. The preparation method of the present invention can be applied to a wide variety of raw materials, and can efficiently achieve uniform mixing of multiple raw materials at the nano level. After being sintered, the mixed slurry can form a perfect layered O3 phase structure. The prepared single-crystal sodium-ion battery cathode material has excellent electrochemical performance and cycle performance when used in a sodium-ion battery.

## Description

### Technical Field

The present invention belongs to the field of sodium-ion battery, and in particular relates to a single-crystal sodium-ion battery cathode active material, a preparation method therefor and use thereof.

### Background

Due to the large radius of sodium ion, available cathode active materials for sodium-ion batteries are relatively limited. At present, sodium-ion battery cathode active materials that have shown potential application prospects include three types: Prussian blue type, layered oxide type, and polyanion type. Among them, layered oxide-type cathode active materials with an O3 phase structure, similar to a ternary cathode active material in lithium ion batteries, have the advantages of high capacity, high compaction density and the like and are regarded as the most promising cathode material and adopted by sodium-ion battery companies at home and abroad.

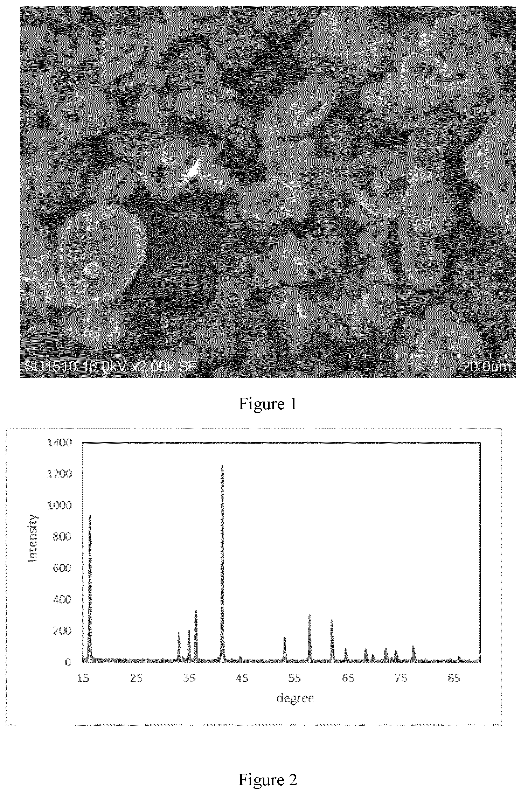

At present, the oxide-type sodium-ion battery cathode active materials mainly have a secondary spherical particle structure. For example, CN110416521A discloses a Mg-doped sodium-ion battery ternary cathode material and a preparation method therefor. The preparation method comprises: step 1: adding 112 parts by weight of Na₂CO₃, 40-50 parts by weight of NiO, 54 parts by weight of Fe₂O₃, 48 parts by weight of MnO, and 0.1-5.6 parts by weight of MgO to 610 parts by weight of deionized water and then carrying out stirring to obtain a mixed solution; step 2: ball milling the mixed solution from step 1 in a nano ball mill for 20-80 min, and then taking out a resulting slurry and spray drying the slurry at 80-120 °C to obtain a precursor powder; and step 3: heating the precursor powder from step 2 to 750-1000 °C at a rate of 2-5 °C/min in an air atmosphere and calcining the precursor powder for 9-15 h, and then cooling the calcined precursor powder to room temperature to obtain a Mg-doped sodium-ion battery ternary cathode material. As shown in FIG. 2 of the patent, by this method, obtained is a fluffy secondary spherical structure with a secondary particle size of about 8 µm and a primary particle size of only 0.15-0.4 µm. This type of spherical structure is easily fractured and has a low compaction density and a large specific surface area. When the battery is cycled, more side reactions occur between the cathode material and electrolyte and more gas is produced, resulting in poor cycle performance and safety performance of the battery.

CN113471431A discloses a NaMn_{0.5}Ni_{0.5}BₓO₂ sodium-ion battery cathode material which has a P2/O3 composite phase and a dense secondary spherical morphology. A preparation method of the cathode material is as follows: Materials including a sodium source, a manganese source, a nickel source and a boron source are mixed according to a molar ratio of Na:Mn:Ni:B being (1-1.05):0.5:0.5:x to obtain a mixture; the mixture is heat-treated in an oxygen-containing atmosphere at 800-900 °C, thus obtaining the cathode material. Although the O3 phase is used in the cathode material to improve the P2 phase, which improves the electrochemical performance compared with a P2 phase material, the method of the described patent cannot prepare a pure O3 phase material, and the corresponding electrochemical performance of the material needs to be further improved.

The described traditional secondary spherical particle structure still has the following problems: 1. The particle structure has poor mechanical strength, which easily leads to breakage of secondary spheres during the compaction of an electrode plate, thereby affecting the compaction density and cycle performance of the electrode plate. 2. The active material has a large contact surface area with the electrolyte, and the contact with the electrolyte leads to more side reactions, thereby affecting the cycle performance and safety performance.

In this regard, those skilled in the art are committed to preparing the oxide-type sodium-ion battery cathode active material into a single crystal morphology. For example, CN109817970A discloses an preparation method for a single-crystal sodium-ion battery electrode material. The method comprises the following steps: mixing a mixture of an iron salt, a manganese salt and an M salt in water with a precipitant, a complexing agent and a dispersant to have a reaction to obtain a solid precursor of the battery electrode material; and mixing the precursor with a sodium salt, sintering a resulting mixture and then cooling the mixture to obtain the single-crystal sodium-ion battery electrode material; wherein ammonium polyacrylate is used as the dispersant. In the large-scale production process of this method, due to the high possibility of low solubility product constant of the iron salt, the iron salt tends to precipitate before other metals, resulting in uneven distribution of co-precipitated materials, and thus directly affecting the electrochemical performance.

### Summary of the Invention

In view of the deficiencies and disadvantages in the prior art, the present invention is intended to provide a preparation method for a single-crystal sodium-ion battery cathode active material. By virtue of the method, a single-crystal sodium-ion battery cathode active material with high compaction density, small specific surface area and excellent electrochemical performance can be stably prepared on a large scale.

In order to solve the described technical problems, a technical solution adopted in the present invention is as follows:

A preparation method for a single-crystal sodium-ion battery cathode active material, wherein the single-crystal sodium-ion battery cathode active material comprises: sodium (Na), metal M, boron (B), and oxygen (O) elements, and the preparation method comprises a step of adding an M-containing compound, a B-containing compound and a sodium source to water to form a slurry and sand grinding the slurry to obtain a mixed slurry and a step of spray drying the mixed slurry and sintering the dried mixed slurry to obtain the single-crystal sodium-ion battery cathode active material.

According to some preferred and specific aspects of the present invention, the single-crystal sodium-ion battery cathode active material has a chemical formula of NaₓM_{y}B_{z}O₂, wherein the M is one or more of Li, Mg, Al, Si, K, Ca, Ti, V, Cr, Mn, Fe, Co, Ni, Cu, Zn, Sr, Y, Zr, Nb, Mo, Ru, In, Sn, Sb, W, Ta, Ba, Bi, La, Ce and Eu, 0.80≤x≤1.40, 0.6≤y≤0.9999, 0.0001≤z≤0.4.

Preferably, in the chemical formula NaₓM_{y}B_{z}O₂, 0.95≤x≤1.05, 0.8≤y≤0.9999, 0.0001≤z≤0.2.

Further preferably, in the chemical formula NaₓM_{y}B_{z}O₂, 0.98≤x≤1.04, 0.9≤y≤0.9999, 0.0001≤z≤0.1.

In some specific embodiments of the present invention, the M is one or more of Fe, Ni, Mn, Cu, and Ti.

In some specific embodiments of the present invention, the M-containing compound is one or more of an oxide, a hydroxide, a carbonate, an oxalate, and a nitrate of the M element.

Further, the M-containing compound is one or more of nickel manganese hydroxide, ferric oxide, titanium dioxide, nickel oxide, and manganese dioxide.

In some specific embodiments of the present invention, the B-containing compound is one or more of boron oxide, boric acid, a borate, a borohydride, a boron trihalide, trifluoroboric acid, a borate ester, borane, and a metal boride.

Further, the B-containing compound is one or more of boric acid and boron oxide.

In some specific embodiments of the present invention, the sodium source is one or more of sodium carbonate, sodium bicarbonate, sodium hydroxide, sodium oxide, sodium peroxide, sodium nitrate, sodium acetate, and sodium oxalate.

Further, the sodium source is one or more of sodium carbonate, sodium bicarbonate, and sodium hydroxide.

In some specific embodiments of the present invention, a molar ratio of the M-containing compound to the B-containing compound to the sodium source is (0.6-0.9999): (0.4-0.0001): (0.80-1.40).

Further preferably, the molar ratio of the M-containing compound to the B-containing compound to the sodium source is (0.9-0.9999): (0.1-0.0001): (0.90-1.10).

Further, the molar ratio of the M-containing compound to the B-containing compound to the sodium source is 0.95:0.05:1.0.

In some specific embodiments of the present invention, the sand grinding time is 0.6 to 7.8 h.

Further, the sand grinding time is 1 to 4 h.

In some specific embodiments of the present invention, a grinding body for the sand grinding is zirconium oxide balls with a particle size of 0.1-0.8 mm.

In some specific embodiments of the present invention, the sand grinding speed is 800 to 3000 rpm.

Further, the sand grinding speed is 1500 to 2500 rpm.

In some specific embodiments of the present invention, a solid content of the mixed slurry is 10% to 60%.

Further, the solid content of the mixed slurry is 20% to 40%.

In some specific embodiments of the present invention, the median size of particles in the mixed slurry is 20 nm to 800 nm.

In some specific embodiments of the present invention, the mixed slurry is pulverized after being sintered.

Further, during the spray drying, a rotation speed of an atomizing disc is 1000 rpm to 3000 rpm, an inlet air temperature is 150 °C to 300 °C, and an outlet air temperature is 80 °C to 120 °C.

In some specific embodiments of the present invention, the sintering is performed in the air at a temperature of 750-1100 °C for 5-25 h.

Further, the sintering is performed at a temperature of 850-1000 °C for 8-16 h.

In the preparation method of the present invention, sand grinding is performed during the preparation of the mixed slurry. In this way, water-soluble materials can be treated so that the water-soluble materials are well mixed at a molecular level on the one hand; on the other hand, water-insoluble raw materials can also be treated so that the water-insoluble raw materials are well mixed at a nano level; moreover, the water-soluble materials and water-insoluble raw materials may also be well mixed at the nano level. The sand grinding ensures that raw materials are well mixed at the nano level, and then the cathode material with excellent electrochemical activity can be stably obtained during high-temperature sintering. In addition, by adding the B-containing compound to the raw materials, nano-level primary particles are quickly melted during the high-temperature sintering, and then a single-crystal sodium-ion battery cathode active material of about 1-30 µm can be obtained by sintering. The cathode active material which is not fluffy has a high compaction density, thereby greatly reducing side reactions between the cathode material and an electrolyte. Moreover, by adjusting the content of B element in the single-crystal cathode active material, the particle size of the single-crystal particles of the cathode active material can be controlled. The sand grinding process and the addition of the B-containing compound also take a synergistic effect, and both are indispensable for the preparation of a perfect single-crystal cathode active material.

In addition, in the present invention, the mixed slurry may also be spray dried. By the spray drying process, multiple raw materials can be uniformly distributed in the mixed slurry during the drying process, thereby ensuring that there is no component segregation of multiple raw materials during the molding process.

The present invention further provides a single-crystal sodium-ion battery cathode active material prepared by the preparation method described above. The cathode active material has a single-crystal structure in microscopic morphology, an average particle size D₅₀ of 1-30 µm, a compaction density of 2.8-3.6 g/cm³, and a specific surface area of 0.2-1.0 m²/g.

The present invention further provides a use of the single-crystal sodium-ion battery cathode active material in a sodium-ion battery cathode.

When the single-crystal sodium-ion battery cathode active material is used in a sodium-ion battery cathode, an obtained sodium-ion button battery has a first capacity of 123-130 mAh/g at 0.1C, 25 °C, a capacity of 117-127 mAh/g at 1C, 60 °C after one cycle, and a capacity of 100-120 mAh/g at 1C, 60 °C after 100 cycles, i.e., a retention rate of 84%-92% at a high temperature of 60 °C after 100 cycles.

The present invention further provides a sodium-ion battery cathode material, comprising a cathode active material, a binder and a conductive agent, wherein the cathode active material comprises the described single-crystal sodium-ion battery cathode active material.

The present invention further provides a sodium-ion battery cathode prepared from the described sodium-ion battery cathode material.

The present invention further provides a sodium-ion battery, comprising a cathode, wherein the cathode comprises the described sodium-ion battery cathode.

Compared with the prior art, the present invention has the following technical advantages:

The preparation method of the present invention can be applied to a wide variety of raw materials, and can efficiently achieve uniform mixing of multiple raw materials at the nano level. After being sintered, the mixed slurry can form a perfect layered O3 phase structure.

In the prior art, raw material particles are too fine, the sintered material is very fluffy and has a large specific surface area, the compaction density of the cathode active material is low when the cathode active material is used for making a cathode, and when the battery is cycled, more side reactions occur between the cathode material and the electrolyte and more gas is produced, resulting in poor cycle performance and safety performance of batteries. In the present application, based on the sand grinding process, by doping the boron (B) element, large single crystals can be prepared and the shortcomings of the prior art can be overcome.

In the present invention, by controlling the content of boron element in the single-crystal cathode active material, single-crystal particles of 1-30 µm in size can be prepared, and the single-crystal particles have stable surface properties and few side reactions with the electrolyte. When used in sodium-ion batteries, the single-crystal particles can ensure a high capacity per gram and significantly improve the cycle performance at a high temperature.

### Brief Description of the Drawings

FIG. 1 is an SEM image of NaNi_{0.32}Fe_{0.33}Mn_{0.32}B_{0.03}O₂ prepared in Example 1;
FIG. 2 is an XRD graph of the NaNi_{0.32}Fe_{0.33}Mn_{0.32}B_{0.03}O₂ prepared in Example 1;
FIG. 3 is a charge-discharge curve diagram of the NaNi_{0.32}Fe_{0.33}Mn_{0.32}B_{0.03}O₂ prepared in Example 1;
FIG. 4 is an SEM image of NaNi_{0.31}Fe_{0.33}Mn_{0.31}B_{0.05}O₂ prepared in Example 2;
FIG. 5 is an XRD graph of the NaNi_{0.31}Fe_{0.33}Mn_{0.31}B_{0.05}O₂ prepared in Example 2;
FIG. 6 is a charge-discharge curve diagram of the NaNi_{0.31}Fe_{0.33}Mn_{0.31}B_{0.05}O₂ prepared in Example 2;
FIG. 7 is a 2.0-4.0 V/1C high-temperature (60 °C) cycle diagram of the NaNi_{0.31}Fe_{0.33}Mn_{0.31}B_{0.05}O₂ prepared in Example 2;
FIG. 8 is an SEM image of NaNi_{0.25}Fe_{0.40}Mn_{0.25}Ti_{0.05}B_{0.05}O₂ prepared in Example 4;
FIG. 9 is an XRD graph of the NaNi_{0.25}Fe_{0.40}Mn_{0.25}Ti_{0.05}B_{0.05}O₂ prepared in Example 4;
FIG. 10 is a charge-discharge curve diagram of the NaNi_{0.25}Fe_{0.40}Mn_{0.25}Ti_{0.05}B_{0.05}O₂ prepared in Example 4;
FIG. 11 is a 2.0-4.0 V/1C high-temperature (60 °C) cycle diagram of the NaNi_{0.25}Fe_{0.40}Mn_{0.25}Ti_{0.05}B_{0.05}O₂ prepared in Example 4;
FIG. 12 is an SEM image of NaNi_{1/3}Fe_{1/3}Mn_{1/3}O₂ prepared in Comparative Example 1;
FIG. 13 is an XRD graph of the NaNi_{1/3}Fe_{1/3}Mn_{1/3}O₂ prepared in Comparative Example 1;
FIG. 14 is a charge-discharge curve diagram of the NaNi_{1/3}Fe_{1/3}Mn_{1/3}O₂ prepared in Comparative Example 1;
FIG. 15 is a 2.0-4.0 V/1C high-temperature (60 °C) cycle diagram of the NaNi_{1/3}Fe_{1/3}Mn_{1/3}O₂ prepared in Comparative Example 1;
FIG. 16 is an SEM image of NaNi_{0.32}Fe_{0.33}Mn_{0.32}B_{0.03}O₂ prepared in Comparative Example 2;
FIG. 17 is an XRD graph of the NaNi_{0.32}Fe_{0.33}Mn_{0.32}B_{0.03}O₂ prepared in Comparative Example 2; and
FIG. 18 is a charge-discharge curve diagram of the NaNi_{0.32}Fe_{0.33}Mn_{0.32}B_{0.03}O₂ prepared in Comparative Example 2.

### Detailed Description of Preferred Embodiments

In order to better understand the content of the invention, further description is given below in conjunction with specific embodiments and drawings. It should be understood that these embodiments are only used to further illustrate the invention rather than to limit the scope of the invention. In addition, it should be understood that after reading the content of the invention, without departing from the principle of the invention, the improvements and adjustments made by those skilled in the art to the invention still fall within the scope of the invention. In the following, unless otherwise specified, all raw materials are purchased from commercial sources.

In the following examples and comparative examples, the charge-discharge curves and high-temperature cycle performance were tested as follows. First, a sodium-ion battery was prepared: 0.64 g of a conductive agent SP and 0.64 g of PVDF dissolved in NMP were added to 20 g of the prepared cathode active material, and a resulting solution was well mixed and then applied to an aluminum foil to make an electrode plate. In an argon-filled glove box, an anode (a metal sodium sheet), a separator (Celgard2700), and an electrolyte (1mol/L NaPF₆+EC:DEC(1:1)+5%FEC) were assembled into a button battery. Then, the charge-discharge curves were tested with a voltage range of 2.0-4.0V, a D/C rate of 0.1C, a current of 13 mA, and a test temperature of 25±2 °C; and the cycle performance was tested with a voltage range of 2.0-4.0V, a D/C rate of 1C, a current of 130 mA, and a test temperature of 60 °C after 100 cycles.

### Example 1

This example provides a sodium-ion battery cathode active material, having a chemical formula of NaNi_{0.32}Fe_{0.33}Mn_{0.32}B_{0.03}O₂. The preparation method of the sodium-ion battery cathode active material comprises the following steps.
(1) 3.2 mol of Ni_{0.5}Mn_{0.5}(OH)₂, 0.825 mol of Fe₂O₃, 0.15 mol of H₃BO₃ and 2.5 mol of Na₂CO₃ were added to 3.5 L of water to obtain a slurry.
(2) The slurry prepared in step (1) was ground for 3 h in a sand grinder at a speed of 2500 rpm to obtain a mixed slurry with an average size of 350 nm, where a grinding body used was zirconium oxide balls with a particle size of 0.2 mm.
(3) The mixed slurry prepared in step (2) was stirred thoroughly in a mixer and pure water was then added to adjust the solid content of the mixed slurry to 30±1%. The mixed slurry was then spray dried by a spray dryer with an atomization frequency of 35 Hz, an inlet air temperature of 190 °C, and an outlet air temperature of 85 °C. The dried product was sintered in an air atmosphere furnace at a temperature of 850-1000 °C for 12 h, and then cooled to 80 °C or below, jaw broken, rolled, and pulverized to obtain a sodium-ion battery cathode active material. The sample of the sodium-ion battery cathode active material was named NFM-B1.

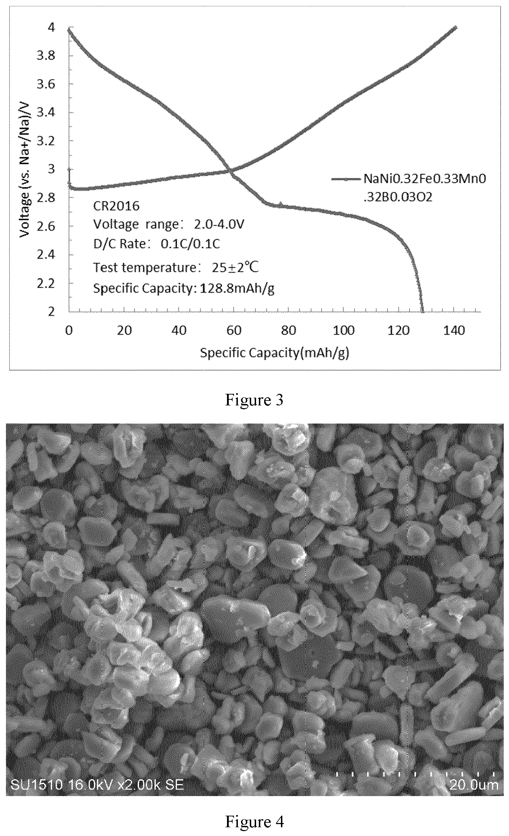

The SEM image of NFM-B1 is shown in FIG. 1, and it can be seen that the material has a single crystal morphology. The XRD graph of NFM-B1 is shown in FIG. 2, and it can be seen that the material has an α-NaFeO2 type pure phase layered structure. The charge-discharge curve diagram of NFM-B1 is shown in FIG. 3, and it can be seen that the specific capacity of discharge within a voltage range of 2.0-4.0V at 0.1C is 128.8 mAh/g.

### Example 2

This example provides a sodium-ion battery cathode active material, having a chemical formula of NaNi_{0.31}Fe_{0.33}Mn_{0.31}B_{0.05}O₂. The preparation method of the sodium-ion battery cathode active material comprises the following steps.
(1) 3.1 mol of Ni_{0.5}Mn_{0.5}(OH)₂, 0.825 mol of Fe₂O₃, 0.25 mol of H₃BO₃ and 2.5 mol of Na₂CO₃ were added to 3.5 L of water to obtain a slurry.
(2) The slurry prepared in step (1) was ground for 3 h in a sand grinder at a speed of 2500 rpm to obtain a mixed slurry with an average size of 350 nm, where a grinding body used was zirconium oxide balls with a particle size of 0.2 mm.
(3) The mixed slurry prepared in step (2) was stirred thoroughly in a mixer and pure water was then added to adjust the solid content of the mixed slurry to 30±1%. The mixed slurry was then spray dried by a spray dryer with an atomization frequency of 35 Hz, an inlet air temperature of 190 °C, and an outlet air temperature of 85 °C. The dried product was sintered in an air atmosphere furnace at a temperature of 850-1000 °C for 12 h, and then cooled to 80 °C or below, jaw broken, rolled, and pulverized to obtain a sodium-ion battery cathode active material. The sample of the sodium-ion battery cathode active material was named NFM-B2.

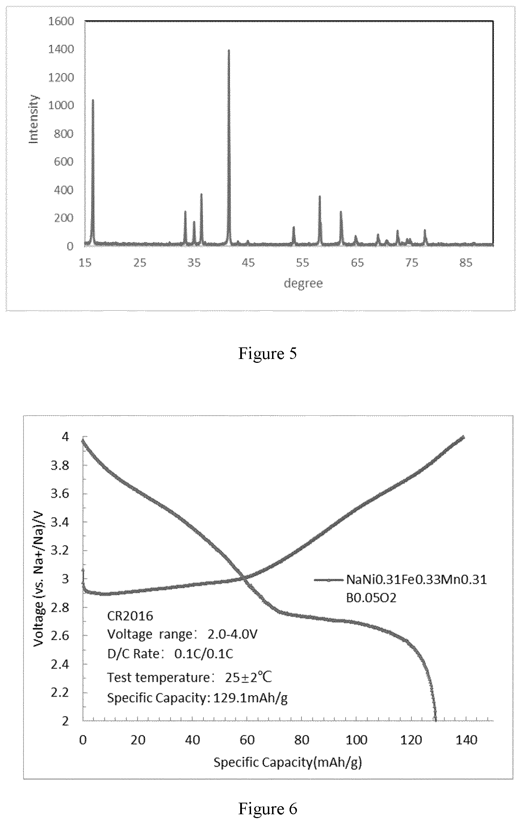

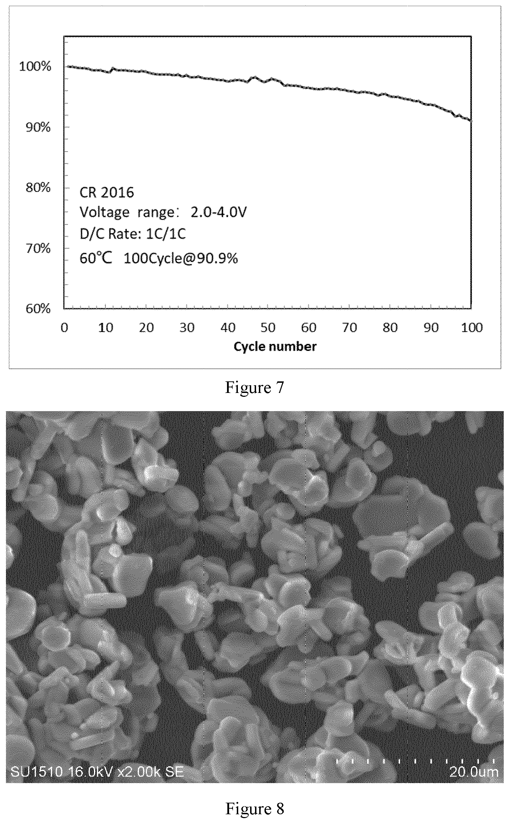

The SEM image of NFM-B2 is shown in FIG. 4, and it can be seen that the material has a single crystal morphology. The XRD graph of NFM-B2 is shown in FIG. 5, and it can be seen that the material has an α-NaFeO2 type pure phase layered structure. The charge-discharge curve diagram of NFM-B2 is shown in FIG. 6, and it can be seen that the specific capacity of discharge within a voltage range of 2.0-4.0V at 0.1C is 129.1 mAh/g. The high-temperature cycle diagram of NFM-B2 is shown in FIG. 7, and it can be seen that at 60 °C, within a voltage range of 2.0-4.0V, 1C, the capacity retention rate after 100 cycles is 90.9%.

### Example 3

This example provides a sodium-ion battery cathode active material, having a chemical formula of NaNi_{0.31}Fe_{0.33}Mn_{0.31}B_{0.05}O₂. The preparation method of the sodium-ion battery cathode active material comprises the following steps.
(1) 1.55 mol of NiO, 1.55 mol of MnO₂, 0.825 mol of Fe₂O₃, 0.25 mol of H₃BO₃, and 2.5 mol of Na₂CO₃ were added to 3.5 L of water to obtain a slurry.
(2) The slurry prepared in step (1) was ground for 3 h in a sand grinder at a speed of 2500 rpm to obtain a mixed slurry with an average size of 350 nm, where a grinding body used was zirconium oxide balls with a particle size of 0.2 mm.
(3) The mixed slurry prepared in step (2) was stirred thoroughly in a mixer and pure water was then added to adjust the solid content of the mixed slurry to 30±1%. The mixed slurry was then spray dried by a spray dryer with an atomization frequency of 35 Hz, an inlet air temperature of 190 °C, and an outlet air temperature of 85 °C. The dried product was sintered in an air atmosphere furnace at a temperature of 850-1000 °C for 12 h, and then cooled to 80 °C or below, jaw broken, rolled, and pulverized to obtain a sodium-ion battery cathode active material. The sample of the sodium-ion battery cathode active material was named NFM-B3.

### Example 4

This example provides a sodium-ion battery cathode active material, having a chemical formula of NaNi_{0.25}Fe_{0.40}Mn_{0.25}Ti_{0.05}B_{0.05}O₂. The preparation method of the sodium-ion battery cathode active material comprises the following steps.
(1) 2.5 mol of Ni_{0.5}Mn_{0.5}(OH)₂, 1 mol of Fe₂O₃, 0.25 mol of TiO₂, 0.25 mol of H₃BO₃, and 2.5mol of Na₂CO₃ were added to 3.5 L of water to obtain a slurry.
(2) The slurry prepared in step (1) was ground for 3 h in a sand grinder at a speed of 2500 rpm to obtain a mixed slurry with an average size of 350 nm, where a grinding body used was zirconium oxide balls with a particle size of 0.2 mm.
(3) The mixed slurry prepared in step (2) was stirred thoroughly in a mixer and pure water was then added to adjust the solid content of the mixed slurry to 30±1%. The mixed slurry was then spray dried by a spray dryer with an atomization frequency of 35 Hz, an inlet air temperature of 190 °C, and an outlet air temperature of 85 °C. The dried product was sintered in an air atmosphere furnace at a temperature of 850-1000 °C for 12 h, and then cooled to 80 °C or below, jaw broken, rolled, and pulverized to obtain a sodium-ion battery cathode active material. The sample of the sodium-ion battery cathode active material was named NFM-TB1.

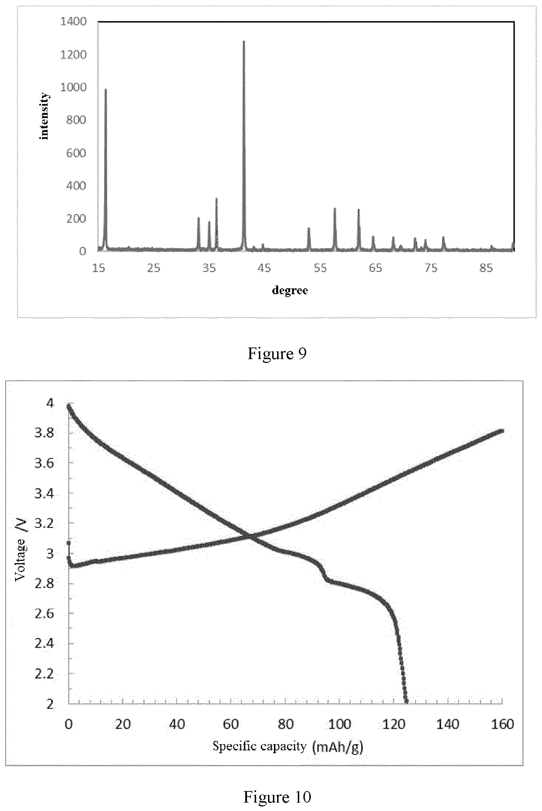

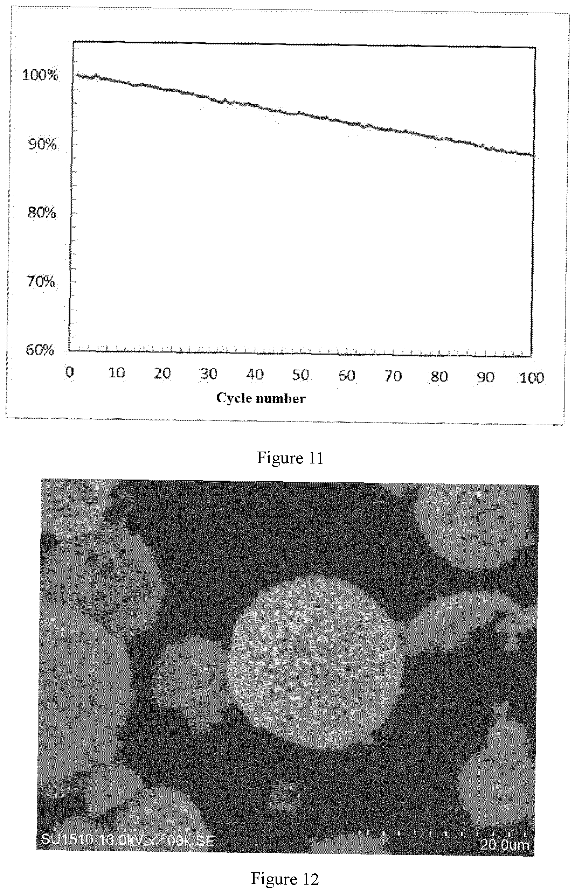

The SEM image of NFM-TB1 is shown in FIG. 8, and it can be seen that the material has a single crystal morphology. The XRD graph of NFM-TB1 is shown in FIG. 9, and it can be seen that the material has an α-NaFeO2 type pure phase layered structure. The charge-discharge curve diagram of NFM-TB1 is shown in FIG. 10, and it can be seen that the specific capacity of discharge within a voltage range of 2.0-4.0V at 0.1C is 124.8 mAh/g. The high-temperature cycle diagram of NFM-TB1 is shown in FIG. 11, and it can be seen that at 60 °C, within a voltage range of 2.0-4.0V, at a D/C rate of 1C, the capacity retention rate after 100 cycles is 89.04%.

### Example 5

This example provides a sodium-ion battery cathode active material, having a chemical formula of NaNi_{0.25}Fe_{0.40}Mn_{0.25}Ti_{0.05}B_{0.05}O₂. The preparation method of the sodium-ion battery cathode active material comprises the following steps.
(1) 1.25 mol of NiO, 1.25 mol of MnO₂, 1 mol of Fe₂O₃, 0.25 mol of TiO₂, 0.25 mol of H₃BO₃, 2.5 mol of Na₂CO₃ were added to 3.5 L of water to obtain a slurry.
(2) The slurry prepared in step (1) was ground for 3 h in a sand grinder at a speed of 2500 rpm to obtain a mixed slurry with an average size of 350 nm, where a grinding body used was zirconium oxide balls with a particle size of 0.2 mm.
(3) The mixed slurry prepared in step (2) was stirred thoroughly in a mixer and pure water was then added to adjust the solid content of the mixed slurry to 30±1%. The mixed slurry was then spray dried by a spray dryer with an atomization frequency of 35 Hz, an inlet air temperature of 190 °C, and an outlet air temperature of 85 °C. The dried product was sintered in an air atmosphere furnace at a temperature of 850-1000 °C for 12 h, and then cooled to 80 °C or below, jaw broken, rolled, and pulverized to obtain a sodium-ion battery cathode active material. The sample of the sodium-ion battery cathode active material was named NFM-TB2.

### Example 6

This example provides a sodium-ion battery cathode active material, having a chemical formula of NaNi_{0.25}Fe_{0.40}Mn_{0.30}B_{0.05}O₂. The preparation method of the sodium-ion battery cathode active material comprises the following steps.
(1) 1.25 mol of NiO, 1.50 mol of MnO₂, 1 mol of Fe₂O₃, 0.25 mol of H₃BO₃, 2.5 mol of Na₂CO₃ were added to 3.5 L of water to obtain a slurry.
(2) The slurry prepared in step (1) was ground for 3 h in a sand grinder at a speed of 2500 rpm to obtain a mixed slurry with an average size of 350 nm, where a grinding body used was zirconium oxide balls with a particle size of 0.2 mm.
(3) The mixed slurry prepared in step (2) was stirred thoroughly in a mixer and pure water was then added to adjust the solid content of the mixed slurry to 30±1%. The mixed slurry was spray dried by a spray dryer with an atomization frequency of 35 Hz, an inlet air temperature of 190 °C, and an outlet air temperature of 85 °C. The dried product was sintered in an air atmosphere furnace at a temperature of 850-1000 °C for 12 h, and then cooled to 80 °C or below, jaw broken, rolled, and pulverized to obtain a sodium-ion battery cathode active material. The sample of the sodium-ion battery cathode active material was named NFM-B4.

### Comparative Example 1

This example provides a sodium-ion battery cathode active material, having a chemical formula of NaNi_{1/3}Fe_{1/3}Mn_{1/3}O₂. The preparation method of the sodium-ion battery cathode active material comprises the following steps.
(1) 3.33 mol of Ni_{0.5}Mn_{0.5}(OH)₂, 0.835 mol of Fe₂O₃, and 2.5 mol of Na₂CO₃ were added to 3.5 L of water to obtain a slurry.
(2) The slurry prepared in step (1) was ground for 3 h in a sand grinder at a speed of 2500 rpm to obtain a mixed slurry with an average size of 350 nm, where a grinding body used was zirconium oxide balls with a particle size of 0.2 mm.
(3) The mixed slurry prepared in step (2) was stirred thoroughly in a mixer and pure water was then added to adjust the solid content of the mixed slurry to 30±1%. The mixed slurry was then spray dried by a spray dryer with an atomization frequency of 35 Hz, an inlet air temperature of 190 °C, and an outlet air temperature of 85 °C. The dried product was sintered in an air atmosphere furnace at a temperature of 850-1000 °C for 12 h, and then cooled to 80 °C or below, jaw broken, rolled, and pulverized to obtain a sodium-ion battery cathode active material. The sample of the sodium-ion battery cathode active material was named NFM-1.

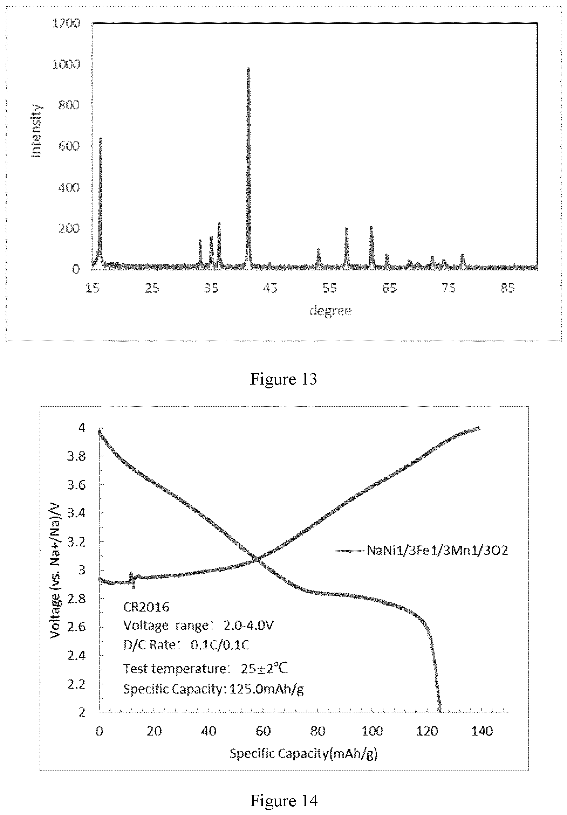

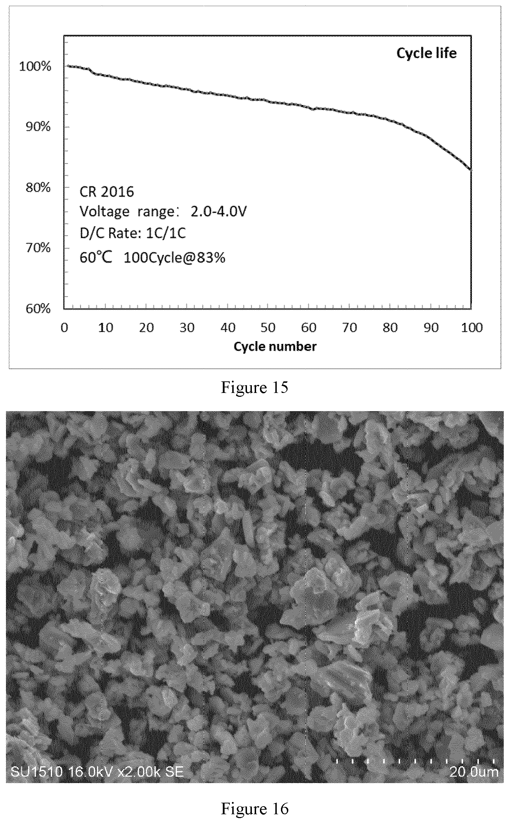

The SEM image of NFM-1 is shown in FIG. 12, and it can be seen that the material is a fluffy secondary particle sphere, with primary particles of about 0.5 µm inside the sphere. The XRD graph of NFM-1 is shown in FIG. 13, and it can be seen that the material has an α-NaFeO2 type pure phase layered structure. The charge-discharge curve diagram of NFM-1 is shown in FIG. 14, and it can be seen that the specific capacity of discharge within a voltage range of 2.0-4.0V at 0.1C is 125.0 mAh/g. The high-temperature cycle diagram of NFM-1 is shown in FIG. 15, and it can be seen that at 60 °C, within a voltage range of 2.0-4.0V, at the D/C rate of 1C, the capacity retention rate after 100 cycles is 83%.

### Comparative Example 2

This example provides a sodium-ion battery cathode active material, having a chemical formula of NaNi_{0.32}Fe_{0.33}Mn_{0.32}B_{0.03}O₂. The preparation method of the sodium-ion battery cathode active material comprises the following steps.
(1) Nickel sulfate, ferrous sulfate and manganese sulfate were added into pure water at a molar ratio of Ni:Fe:Mn being 1:1:1 to prepare a solution with a total concentration of metal elements being 1.3 mol/L.
**(2)** A 4.0 mol/L sodium hydroxide solution and a 5.0 mol/L ammonia solution were prepared.
(3) The metal salt solution obtained in step (1) and the sodium hydroxide solution and ammonia solution obtained in step (2) were added to a reactor at a rate of 2.5 L/h, 1.5 L/h and 0.2 L/h, respectively, and the reaction was performed for 12 h at a reaction temperature of 50 °C, a reaction pH of 11.5, a stirring speed of 650 rpm to obtain a precursor.
(4) The precursor was washed with pure water and then filtered and dried to obtain Ni_{1/3}Fe_{1/3}Mn_{1/3}(OH)₂.
(5) The precursor, boric acid and sodium carbonate were mixed and ground, wherein the molar ratio of the total amount of metal elements in the precursor to B to the Na in the sodium carbonate was 0.97:0.03:1; the resulting mixture was then sintered in an air atmosphere furnace at 850-1000 °C for 12 h, and then cooled to 80 °C or below, jaw broken, rolled, and pulverized to obtain a sodium-ion battery cathode active material. The sample of the sodium-ion battery cathode active material was named NFM-B5.

In the preparation method, since no water was added when the precursor was ground, no mixed slurry is prepared, and no spray drying is performed before sintering.

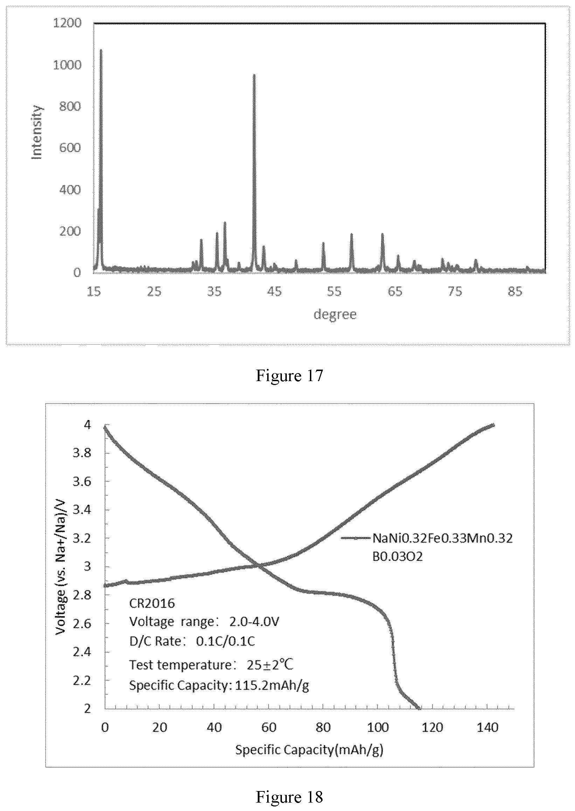

The SEM image of NFM-B5 is shown in FIG. 16, and it can be seen that the material has a single crystal-like structure with an irregular shape. The XRD graph of NFM-B5 is shown in FIG. 17, and it can be seen that the material has a P2/O3 composite phase structure. The charge-discharge curve diagram of NFM-B5 is shown in FIG. 18, and it can be seen that the specific capacity of discharge within a voltage range of 2.0-4.0V at 0.1C is 115.2 mAh/g.

### Performance testing

The cathode active materials prepared in the described Examples 1-6 and Comparative Examples 1-2 were tested for physicochemical performance, and the physicochemical performance results are shown in Table 1 below.

**Table 1. Physical properties of cathode active materials**

| No. | Sample | D10 /µm | D50 /µm | D90 /µm | Compaction density (g/cm³) | Specific surface area (m²/g) |
|---|---|---|---|---|---|---|
| Example 1 | NFM-B1 | 3.34 | 5.88 | 10.09 | 3.11 | 0.70 |
| Example 2 | NFM-B2 | 4.23 | 7.85 | 13.7 | 3.40 | 0.47 |
| Example 3 | NFM-B3 | 4.33 | 8.27 | 14.78 | 3.41 | 0.51 |
| Example 4 | NFM-TB1 | 2.08 | 7.72 | 17.89 | 3.33 | 0.59 |
| Example 5 | NFM-TB2 | 3.76 | 9.08 | 19.89 | 3.49 | 0.44 |
| Example 6 | NFM-B4 | 3.66 | 6.91 | 12.65 | 3.29 | 0.69 |
| Comparative Example 1 | NFM-1 | 3.17 | 10.92 | 17.29 | 2.55 | 1.55 |
| Comparative Example 2 | NFM-B5 | 2.51 | 5.76 | 27.10 | 2.72 | 1.28 |

The cathode active materials prepared in the above Examples 1-6 and Comparative Examples 1-2 were used for performance testing of a sodium-ion battery. The sodium-ion battery was prepared as follows: 0.64 g of a conductive agent SP and 0.64 g of PVDF dissolved in NMP were added to 20 g of the prepared cathode active material, and a resulting solution was well mixed and then applied to an aluminum foil to make an electrode plate. In an argon-filled glove box, an anode (a metal sodium sheet), a separator (Celgard2700), and an electrolyte (1mol/L NaPF₆+EC:DEC(1:1)+5%FEC) were assembled into a button battery. The test was performed with a voltage range of 2.0-4.0V, a D/C rate of 0.1C, and a current of 13 mA, and the test results are shown in Table 2 below.

**Table 2. Properties of sodium-ion button batteries**

| No. | Sample | Initial discharge capacity per gram (mAh/g) | Discharge capacity per gram after one cycle (mAh/g) | Discharge capacity per gram after 100 cycles (mAh/g) | Retention rate after 100 cycles (%) |
|---|---|---|---|---|---|
| | | 0.1C, 25 °C | 1C, 60 °C | 1C, 60 °C | |
| Example 1 | NFM-B1 | 128.8 | 124.6 | 109.4 | 87.84% |
| Example 2 | NFM-B2 | 129.1 | 126.8 | 115.3 | 90.9% |
| Example 3 | NFM-B3 | 126.5 | 125.9 | 112.3 | 89.24% |
| Example 4 | NFM-TB1 | 124.8 | 117.6 | 104.7 | 89.04% |
| Example 5 | NFM-TB2 | 123.7 | 118 | 104.6 | 88.68% |
| Example 6 | NFM-B4 | 131.1 | 128.2 | 108.7 | 84.8% |
| Comparative Example 1 | NFM-1 | 125.0 | 121.1 | 100.5 | 83% |
| Comparative Example 2 | NFM-B5 | 115.2 | 101.6 | 77.9 | 76.7% |

As can be seen from Tables 1-2 above, in the present invention, since water was added to the precursor during grinding to form a mixed slurry, spray drying was performed before sintering, and a B-containing compound was added to the raw materials, the cathode active material can form a perfect single-crystal layered structure, the single crystal particles are large and densely grown, the compaction density of the cathode active material is significantly increased, and the specific surface area is reduced. When the cathode active material is used in a sodium-ion battery, on the premise of ensuring high capacity per gram, the cycle performance at a high temperature can be significantly improved.

The described examples are only for illustrating the technical concept and features of the invention so that those familiar with the technology can understand the content of the invention and implement the invention accordingly. These examples cannot be used to limit the scope of the invention. All equivalent changes or modifications made according to the spirit and essence of the invention should fall within the scope of the invention.

## Claims

1. A preparation method for a single-crystal sodium-ion battery cathode active material, wherein the single-crystal sodium-ion battery cathode active material comprises: sodium, metal M, boron, and oxygen elements, **characterized in that,** the preparation method comprises a step of adding an M-containing compound, a B-containing compound and a sodium source to water to form a slurry and sand grinding the slurry to obtain a mixed slurry and a step of spray drying the mixed slurry and sintering the dried mixed slurry to obtain the single-crystal sodium-ion battery cathode active material.

2. The preparation method according to claim 1, **characterized in that,** the single-crystal sodium-ion battery cathode active material has a chemical formula of NaₓM_{y}B_{z}O₂, wherein the M is one or more of Li, Mg, Al, Si, K, Ca, Ti, V, Cr, Mn, Fe, Co, Ni, Cu, Zn, Sr, Y, Zr, Nb, Mo, Ru, In, Sn, Sb, W, Ta, Ba, Bi, La, Ce, and Eu, 0.80≤x≤1.40, 0.6≤y≤0.9999, 0.0001≤z≤0.4.

3. The preparation method according to claim 1, **characterized in that,** the M-containing compound is one or more of an oxide, a hydroxide, a carbonate, an oxalate, and a nitrate of the M element.

4. The preparation method according to claim 1, **characterized in that,** the B-containing compound is one or more of boron oxide, boric acid, a borate, a borohydride, a boron trihalide, trifluoroboric acid, a borate ester, borane, and a metal boride.

5. The preparation method according to claim 1, **characterized in that,** the sodium source is one or more of sodium carbonate, sodium bicarbonate, sodium hydroxide, sodium oxide, sodium peroxide, sodium nitrate, sodium acetate, and sodium oxalate.

6. The preparation method according to claim 1, **characterized in that,** a molar ratio of the M-containing compound to the B-containing compound to the sodium source is (0.6-0.9999): (0.4-0.0001): (0.80-1.40).

7. The preparation method according to claim 1, **characterized in that,** the sand grinding time is 0.6 to 7.8 h; and/or, a grinding body for the sand grinding is zirconium oxide balls with a particle size of 0.1-0.8 mm; and/or, the sand grinding speed is 800 to 3000 rpm.

8. The preparation method according to claim 1, **characterized in that,** a solid content of the mixed slurry is 10% to 60%; and/or, the median size of particles in the mixed slurry is 20 nm to 800 nm.

9. The preparation method according to claim 1, **characterized in that,** during the spray drying, a rotation speed of an atomizing disc is 1000 rpm to 3000 rpm, an inlet air temperature is 150 °C to 300 °C, and an outlet air temperature is 80 °C to 120 °C.

10. The preparation method according to claim 1, **characterized in that,** the sintering is performed in the air at a temperature of 750-1100 °C for 5-25 h; and/or, the mixed slurry is pulverized after being sintered.

11. A single-crystal sodium-ion battery cathode active material prepared by the preparation method according to any one of claims 1-10, **characterized in that,** the single-crystal sodium-ion battery cathode active material has a single-crystal structure in microscopic morphology, an average particle size D₅₀ of 1-30 µm, a compaction density of 2.8-3.6 g/cm³, and a specific surface area of 0.2-1.0 m²/g.

12. Use of the single-crystal sodium-ion battery cathode active material according to claim 11 in a sodium-ion battery cathode.

13. A sodium-ion battery cathode material, comprising a cathode active material, a binder and a conductive agent, **characterized in that,** the cathode active material comprises the single-crystal sodium-ion battery cathode active material according to claim 11.

14. A sodium-ion battery cathode, **characterized in that, the sodium-ion battery cathode is** prepared from the sodium-ion battery cathode material according to claim 13.

15. A sodium-ion battery, comprising a cathode, **characterized in that,** the cathode comprises the sodium-ion battery cathode according to claim 14.
